(19) Europäisches Patentamt
European Patent Office
Office européen des brevets

(11) Publication number: 0 224 727 A1

# (12) EUROPEAN PATENT APPLICATION

(21) Application number: 86115150.4

(22) Date of filing: 31.10.86

(51) Int. Cl.[4]: C08J 5/06, C08J 5/08, C08L 63/00, C03C 25/02

(30) Priority: 13.11.85 US 797555

(43) Date of publication of application: 10.06.87 Bulletin 87/24

(84) Designated Contracting States: DE FR GB IT

(71) Applicant: International Business Machines Corporation
Old Orchard Road
Armonk, N.Y. 10504(US)

(72) Inventor: Bhatt, Anilkumar Chinuprasad
112 Andrews Ave. No. b1
Endicott N.Y. 13 760(US)
Inventor: Snyder, Randy William
144 Meeker Road
Vestal N.Y. 13 850(US)
Inventor: Summa, William Joseph
1022 Elmwood Drive
Endwell N.Y. 13 760(US)

(74) Representative: Kreidler, Eva-Maria, Dr. rer. nat.
Schönaicher Strasse 220
D-7030 Böblingen(DE)

## (54) Process for preparing reinforced epoxy product and product.

(57) A fibrous substrate is coated with a silane in an amount of at least about 0.2 % by weight based upon the fibrous substrate. The substrate is then coated with a composition containing a polyepoxide. A product is provided which includes a fibrous substrate coated with a silane in an amount of at least about 0.2 % by weight based upon the substrate and then subsequently coated with a composition containing a polyepoxide. Enhanced adhesion between the fibrous substrate and the polyepoxide is provided.

EP 0 224 727 A1

## Process for Preparing Reinforced Epoxy Product and Product

The present invention is concerned with a method for producing a fiber reinforced polyepoxide products and the product obtained thereby. In particular, the present invention is concerned with producing so-called prepreg polyepoxide substrates.

A number of fiber reinforced plastics are used commercially for various purposes. Articles such as sheets, tapes, or fabrics wherein fibers are impregnated with a resin such as an epoxy resin are referred to as "prepreg substrates". One important use of prepreg substrates is to provide a surface upon which a pattern of an electrical conductor can be provided to obtain circuit boards or circuit cards. The printed circuit boards or printed circuit cards are prepared from laminates of multiple layers of the fiber impregnated epoxy resin compositions. These laminates need to be resistant to various solvents since they are repeatedly exposed to processing solvents and vapors thereof. For instance, in many instances photoresists are stripped from the surface of metal, bonded to the surface of a laminate by exposing the photoresist to solvents which can cause leaching and softening of various materials.

Moreover, it is desired that the laminates be self-extinguishing and that the epoxy employed act as a fire retardant. The materials also should have a high heat distortion temperature in order to avoid warpage when exposed to high processing temperatures. A further requirement for the epoxy composition is that it have sufficient adhesive power for bonding metal film to the surface of the laminate.

A still further concern is to provide tenacious adhesion between the fibrous substrate and the epoxy composition.

In order to enhance the adhesion between the epoxy composition and fibrous substrate, the substrates have been coated with silanes in amounts which have attempted to approach monolayers and, accordingly, extremely small amounts significantly less than 0.2 % by weight based upon the fibrous substrate have been suggested. Although the use of silanes in such amounts has proved to provide quite good adhesion with the epoxy compositions, there still remains room for additional enhancement in the bonding strength between the epoxy and the fibrous substrate.

Object of the present invention is a process for preparing fiber reinforced polyepoxide articles. In particular, the object of the present invention is achieved by coating a fibrous substrate with a silane in an amount of at least about 0.2 % by weight based upon the weight of the substrate. The coated substrate is then coated with a composition containing a polyepoxide.

In addition, the present invention is concerned with a product which comprises a fibrous substrate coated with a silane in an amount of at least about 0.2 % by weight based upon the weight of the fibrous substrate and subsequently coated with a composition containing a polyepoxide.

The fibrous substrate employed in accordance with the present invention includes such materials as fiberglass, polyamides, and graphite. The preferred fibrous substrates are fiberglass or woven glass fabric.

Examples of some glass fabrics available include those having the standard designations 1675, 106, 108, and 1080.

It is critical to the success of the present invention that the fibrous substrate be coated with at least about 0.2 % by weight of a silane, preferably about 0.2 % to about 0.4 % by weight of a silane, and most preferably about 0.25 % to about 0.4 % by weight of a silane based upon the weight of the fibrous substrate. It has been found, in accordance with the present invention, that contrary to the tendency in the prior art to attempt to provide as small amount of material as possible in order to achieve a monolayer, that improved adhesive results are achieved when the amount of silane employed is at least about 0.2 % by weight based upon the weight of the substrate. The silane acts as a coupling agent to improve the bond between the epoxy polymer and the fibrous substrate.

Typical organofunctional groups found in the silanes include the vinyl, epoxy, methacrylate, amine, and styryl amine groups. The silane coupling agents are well-known in the art. Examples of some specific silanes which are suitable are gamma glycidoxypropyltrimethoxy silane, available under the trade designations Dow Corning Z6040 and Union Carbide A187; N-beta (aminoethyl)-gamma aminopropyltrimethoxy silane, available under the trade designation Union Carbide A1120; vinyltriethoxy silane; (beta-3,4-epoxycyclohexyl)-ethyltrimethoxy silane; and N (vinylbenzylaminoethyl)-gamma aminopropyltrimethoxy silane, available under the trade designation Dow Corning Z6032. Mixtures of silanes can be employed if desired.

The silanes are generally applied to the fibrous substrates by preparing solutions of such in water and then contacting the substrates with the solutions. The silanes are hydrolyzed when placed in aqueous acidic media of suitable pH range.

Suitable organo silanes can be represented by the following formula:

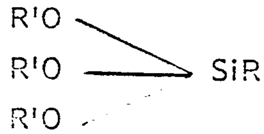

wherein R′ is a hydrocarbon group and usually an alkyl of 1-6 carbon atoms and preferably 1-2 carbon atoms and R is an organo-substituted alkyl radical such as amino-and/or epoxy-substituted alkyl radical in which the alkyl groups have from 1-6 carbon atoms.

Typical epoxy resins include bisphenol A type resins obtained from bisphenol A and epichlorohydrin, and from brominated bisphenol A and epichlorohydrin, resinous materials obtained by the epoxidation of novolak resins produced from a phenolic material such as phenol and an aldehyde such as formaldehyde with epichlorohydrin, polyfunctional epoxy resins such as polyglycidyl ethers of tetraphenylene and tetraglycidyldiaminodiphenyl methane, and alicyclic epoxy resins such as bis - (3,4-epoxy-6-methyl-cyclohexylmethyl) adipate. The most preferred epoxy employed is of the brominated bisphenol A type. In addition, mixtures of epoxy resins can be employed when desired.

The epoxy resinous compositions also can contain curing agents and accelerating agents as well-known in the art.

Examples of suitable curing agents include anhydrides such as chlorendic anhydrides, nadic anhydride, methyltrimellitic anhydride; carboxylic acids; polyamides; polysulfides; ureaphenolformaldehydes; polyamines; primary, and secondary, and tertiary amines. The preferred curing agent in the preferred epoxy compositions employed in the present invention is dicyandiamide. Moreover, mixtures of such with tertiary amines provide for faster curing rates. Such tertiary amines include benzyldimethyl amine, α-methyl benzyldimethyl amine, dimethylaminomethylphenol, tris-(dimethylaminomethylphenol), and N,N,N′,N′-tetramethyl-1,3-butanediamine.

In addition, the epoxy resin is generally applied in the form of a solution in a suitable organic solvent. Suitable solvents include ketones such as acetone and methylethyl ketone; ethers such as ethylene glycol monomethyl ether; and dimethylformamide.

The preferred epoxy compositions employed in accordance with the present invention are disclosed in U.S. Patent 3,523,037, disclosure of which is incorporated herein by reference.

In general, the preferred epoxy compositions employed in the present invention are comprised of an epoxy resin having a high functionality of from about 3.5 to about 6, a second epoxy resin having a relatively low functionality of about 1.7 to about 2, a curing agent, and a curing catalyst such as a tertiary amine. The second epoxy resin may be halogenated or non-halogenated.

In a more preferred aspect, such compositions contain a brominated epoxy resin in an amount of about 70 to about 90 parts per hundred parts by weight of the resin solids in the composition; a tetrafunctional epoxy resin in an amount of about 10 to about 30 parts by weight per hundred parts by weight of the resin solids in the composition; dicyandiamide in a amount of about 3 to about 4 parts by weight per hundred parts by weight of solids in the composition; about 0.2 to about 0.4 parts by weight per hundred parts by weight of solids in the composition of a tertiary amine; about 40 parts by weight based upon the total weight of the composition of ethylene glycol monomethyl ether; and methylethyl ketone in an amount necessary to provide a specific gravity of about 1.085 ± 0.005 to the composition.

The brominated epoxy resin is based on polyglycidyl ether of tetrabromobisphenol A and can be prepared from tetrabromobisphenol A and epichlorohydrin. Such has a functionality of about 2, an epoxide equivalent weight of about 455 to about 500, and a bromine content of about 19 % to about 23 % by weight. Such can be obtained under the trade designation Araldite 8011 from CIBA Products Company as a solution containing about 75 % epoxy resin by weight of methylethyl ketone. Also, such can be obtained under the trade designation DER-511 from the Dow Chemical Company as an 80 % solution of the resin in methylethyl ketone.

The tetrafunctional epoxy resin is the polyglycidyl ether of tetraphenylene and is prepared from tetra bis (hydroxyphenyl) ethane and epichlorohydrin. The epoxy resin has an average functionality of about 4 and an epoxide equivalent weight of about 210 to about 240. Such is available under the trade designation Epon 1031 from the Shell Chemical Corporation as a solution containing about 80 % by weight of solids in methylethyl ketone. Such is also available under the trade designation Araldite 0163 from CIBA Geigy Company. Other suitable multifunctional epoxides are epoxidized novolak such as CIBA 12XX series and Dow 4XX series.

The glass fabric commonly about 0.0508 mm to about 0.254 mm in thickness is first impregnated by dipping through an aqueous solution of the silane in its hydrolyzed form.

The pH of the silane solution should be between about 3 to about 4.5 during coating for best results. This pH can be achieved by providing acids (e.g. -formic acid or acetic acid) in the silane solution.

Since alkali is normally present on the glass when received, the pH of the silane solution can shift during the coating due to dissolution of the alkali therein. For best results, the pH of the silane solution should be maintained throughout the coating in the desired range which can be accomplished by limiting the time any particular silane solution is used, or by adding acid during use to the silane solution, or by replenishing fresh hydrolyzed silane solution, or by prewashing the glass substrate to remove alkali which is normally present.

In addition, the silane solution is usually used within about 12 hours and preferably within about 8 hours after hydrolysis of the silane in order to ensure against excessive polymerization and condensation prior to use.

After the glass cloth is removed from the aqueous silane composition, excess material not impregnated into the fibers can be removed by squeezing the fabric between doctor blades.

The glass cloth containing the silane coating is then dried in an oven at temperatures between about 38°C and about 177°C and preferably between about 116°C and about 121°C to remove water and cause the desired polymerization of the silane. The residence time in the oven is about 7 to about 10 seconds.

The glass fibers containing the silane are then coated with the epoxy composition. The amount of epoxy employed is about 25 % to about 65 % by weight of epoxy solids based upon the glass fabric. The glass fabric is coated with the epoxy composition in the same manner as disclosed in U.S. Patent 3,523,037, disclosure of which is incorporated herein by reference.

In particular, the glass fabric is directed into a container containing the epoxy composition. After being impregnated, the fabric is then passed through a pair of doctor blades whereby excess epoxy resin solution is removed from the surface of the woven glass fabric.

After combining with the reinforcing fibers, the epoxy composition is then cured to the B-stage and molded to the desired shape, such as a sheet.

When sheets are employed, the thickness is usually about 0.038 mm to about 0.2032 mm and preferably about 0.0508 mm to about 0.1270 mm.

The curing to the B-stage is generally achieved by using temperatures between about 93°C and about 177°C and for times of about 3 minutes to about 10 minutes.

The now impregnated fabric or prepreg can be divided into sheets of desired size in preparation for lamination to form the printed circuit board. The number of sheets of prepreg in any given laminate will depend upon the thickness and weight per unit area of the original glass cloth, the ratio of resin to glass in the prepreg, laminating pressure, and other factors. The number of sheets may vary from 1 to 20 or more, depending on the above factors. Typically, about 2 sheets of the prepreg are interleaved between sheets of electrolytic copper foil and placed between two polished metal plates.

This assembly of prepregs and metal plates and copper foils is then placed between platens of a laminating press. The platens are cored for steam or super-heated water so that they can be heated to elevated temperatures.

The above assembly is subjected to pressures which may vary from about 345 kPa to about 13 800 kPa, depending upon the resin content, flow of the prepreg, and laminate temperatures. Preferably, the pressures are about 1 380 kPa to about 3 450 kPa and most preferably about 1 725 kPa to about 2 070 kPa. The laminate temperature is preferably about 150°C to about 200°C.

The time of the pressing operation is variable, depending upon the particular materials employed and the pressure applied. About 1 hour is adequate for the above conditions.

The following non-limiting examples are further presented to illustrate the present invention.

## EXAMPLE 1

A roll of woven glass fabric having the general designation as 108 is impregnated with an aqueous solution of about 2 % by weight gamma glycidoxypropyltrimethoxy silane in acetic acid to provide a pH of about 3 to about 4.5. The fabric is removed from the solution and excess silane composition is removed by squeezing between two doctor blades. The fabric contains about 0.3 % by weight of the silane. The fabric is placed in an oven and heated to about 116°C to about 120°C for about 7 to 10 seconds in order to remove water and cause polymerization of the silane.

Next, the fabric is coated with an epoxy composition. The epoxy composition is compounded as follows: forty parts by weight of ethyleneglycolmonomethylether is placed in a jacketed vessel equipped with a propeller type stirrer. This solvent is heated to about 43°C ± 9.5°C with agitation by circulating hot water through the jacket of the mixing vessel. When the solvent reaches a temperature of about 38°C, four parts of dicyandiamide are

added thereto. Agitation is continued for 15 to 20 minutes to completely dissolve the dicyandiamide. When the dicyandiamide has been dissolved, the solution is cooled to about room temperature.

In a separate mixing tank about 12.5 parts of an 80 % polyglycidyl ether of tetraphenylene solution is added to about 120 parts of a 75 % polyglycidyl ether of tetrabromobisphenol A solution and is agitated. The dicyandiamide-glycol monomethylether solution is then added to the epoxy resin solution with stirring. The resulting solution is adjusted to a specific gravity of about 1.085 ± 0.005 by the addition of methylethyl ketone.

Next, about 0.2 to about 0.4 parts by weight of N,N,N′,N′-tetramethyl-1,3-butane diamine is added with stirring.

After the sheet is removed from the epoxy solution, the fabric is passed through a pair of doctor blades to remove excess epoxy solution therefrom. The amount of epoxy solids to glass fabrics employed is about 60 ± 3 percent of the total mixture.

The glass fabrics are then placed in an oven to cure the epoxy to the partially cured B-stage by heating at temperatures between about 93°C and about 121°C for about 1 minute followed by about 2 minutes at about 149°C and then about 1 minute at about 138°C to about 160°C.

Two like sheets of this impregnated glass fabric are then laminated between sheets of electrolytic copper foil.

Adhesive tests on the laminate show very few adhesive failures. The tests demonstrate improved resistance to moisture attacks at the interface of the epoxy and glass substrate and improved resistance to delamination. The tests employed are what is referred to as solder blister tests.

The tests are performed upon laminates about 1.016 mm thick with dimensions of 10.16 cm by 10.16 cm and having the copper etched from one surface thereof. The test laminates are cooked for about 30 to about 60 minutes at about 0.98 to about 1.5 bars of pressure in a pressure cooker.

The laminates are then removed from the pressure cooker and dipped into molten solder at about 260°C to about 266°C for about 15 seconds. The laminates are then observed for the presence of blisters.

EXAMPLE 2

Example 1 is repeated, except that the glass fabric employed is referred to as 1675 and the amount of epoxy is about 52 ± 2 % by weight of solids in the final composition. The results obtained are similar to those of Example 1.

EXAMPLE 3

Example 1 is repeated, except that the glass fabrics employed are those designated as 106 and the amount of epoxy is about 60 % to about 68 % by weight of the combination of glass fabric and epoxy solids. The results obtained are similar to those of Example 1.

EXAMPLE 4

Example 1 is repeated, except that the silane solution contains about 0.7 % by weight of N-(vinylbenzylaminoethyl) gamma aminopropyltrimethoxy silane and about 0.3 % to about 0.4 % by weight of gamma glycidoxypropyl trimethoxy silane in acetic acid to provide a pH of about 3 to 4.5. The results obtained are similar to those of Example 1.

Tests on prepreg whereby the silane employed is in amounts much less than 0.2 % by weight in attempts to provide a mono-layer as desired in the prior art were conducted and show significantly lower adhesive characteristics than those achieved by the present application.

**Claims**

1. Process which comprises coating a fibrous substrate with a silane in an amount of at least about 0.2 % by weight based upon the substrate; then coating the substrate with a composition containing a polyepoxide.

2. Process of claim 1 wherein the amount of silane is about 0.2 % to about 0.4 % by weight based upon the substrate.

3. Process of claim 1 wherein the amount of silane is about 0.25 % to about 0.4 % by weight based upon the substrate.

4. Process of claim 1 wherein said fibrous substrate is fiberglass.

5. Process of claim 1 wherein said silane includes an organo-functional group selected from the group of vinyl, epoxy, methacrylate, amine, and styryl amine.

6. Process of claim 1 wherein said silane is an organo silane represented by the formula:

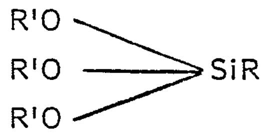

wherein R′ is a hydrocarbon group and R is an organo-substituted alkyl radical wherein the alkyl groups have from 1 to 6 carbon atoms.

7. Process of claim 6 wherein R′ is an alkyl group of 1 to 6 carbon atoms.

8. Process of claim 1 wherein said silane contains gamma glycidoxypropyltrimethoxy silane.

9. Process of claim 1 wherein said silane contains N(vinylbenzylaminoethyl)gamma aminopropyltrimethoxy silane.

10. Process of claim 1 wherein said silane is applied as an aqueous solution having a pH of about 3 to about 4.5.

11. Process of claim 10 wherein said aqueous solution contains acetic acid or formic acid.

12. Process of claim 1 wherein said epoxy composition contains a brominated epoxy resin.

13. Process of claim 1 wherein the amount of epoxy is about 25 % to about 65 % by weight based upon the fibrous substrate.

14. Process of claim 1 which further includes curing the epoxy to the B-stage.

15. Process of claim 14 wherein said curing is carried out by heating at temperatures between about 150°C to about 200°C.

16. Product comprising a fibrous substrate coated with a silane in an amount of at least about 0.2 % by weight based upon the substrate and then subsequently coated with a polyepoxide.

17. Process for preparing a laminate which comprises coating a fibrous substrate with a silane in an amount of at least about 0.2 % by weight based upon the substrate; then coating the substrate with a composition containing a polyepoxide; curing the epoxide to its B-stage, and pressing together multiple layers of the substrate containing the silane and polyepoxide; and then further curing the epoxy.

European Patent Office

# EUROPEAN SEARCH REPORT

Application number

EP 86 11 5150

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| P,X | EP-A-0 166 240 (ALLIED CORP.)<br>* Claims 1-6,8 * | 1-3,5-8,16 | C 08 J 5/06<br>C 08 J 5/08<br>C 08 L 63/00<br>C 03 C 25/02 |
| X | GB-A-1 332 012 (DOW CORNING CORP.)<br>* Claims 1-13; page 2, lines 3-15,40-56; example * | 1-8,16,17 | |
| Y | | 1-8,12-17 | |
| Y | GB-A-2 054 460 (GENERAL ELECTRIC)<br>* Claim 1; page 1, lines 59-63 * | 1-8,12-17 | |
| | | | **TECHNICAL FIELDS SEARCHED (Int. Cl.4)** |
| X | US-A-3 027 274 (D.P. HUNTINGTON et al.)<br>* Claims 1-7,10,15; column 4, lines 42-47 * | 1-7,16,17 | C 08 J<br>C 03 C |
| A | US-A-2 931 739 (A. MARZOCCHI et al.)<br>* Claims 1-3,7-11; column 3, lines 40-50 * | 1-5,10,11,16,17 | |
| A | EP-A-0 055 443 (PPG)<br>* Claims; page 14, line 1 - page 16, line 3 * | 10,11 | |

-/-

The present search report has been drawn up for all claims

| Place of search | Date of completion of the search | Examiner |
|---|---|---|
| THE HAGUE | 12-03-1987 | HALLEMEESCH A.D. |

**CATEGORY OF CITED DOCUMENTS**

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03.82

European Patent Office

# EUROPEAN SEARCH REPORT

Application number

EP 86 11 5150

Page 2

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| D,A | US-A-3 523 037 (L.N. CHELLIS)<br>* Claim 1 *<br>--- | 12 | |
| A | GB-A-1 347 186 (OWENS-CORNING FIBERGLAS)<br>* Claims 1,7,24 *<br>----- | 11 | |

TECHNICAL FIELDS SEARCHED (Int. Cl.4)

The present search report has been drawn up for all claims

| Place of search | Date of completion of the search | Examiner |
|---|---|---|
| THE HAGUE | 12-03-1987 | HALLEMEESCH A.D. |

CATEGORY OF CITED DOCUMENTS

X : particularly relevant if taken alone
Y : particularly relevant if combined with another document of the same category
A : technological background
O : non-written disclosure
P : intermediate document
T : theory or principle underlying the invention
E : earlier patent document, but published on, or after the filing date
D : document cited in the application
L : document cited for other reasons
& : member of the same patent family, corresponding document